(19) Europäisches Patentamt
European Patent Office
Office européen des brevets

(11) EP 2 243 857 B1

(12) **EUROPEAN PATENT SPECIFICATION**

(45) Date of publication and mention
of the grant of the patent:
**19.12.2012 Bulletin 2012/51**

(51) Int Cl.:
*C23C 14/34* (2006.01)    *C01B 21/064* (2006.01)
*C23C 14/06* (2006.01)

(21) Application number: **09711697.4**

(22) Date of filing: **17.02.2009**

(86) International application number:
**PCT/JP2009/052615**

(87) International publication number:
**WO 2009/104567 (27.08.2009 Gazette 2009/35)**

(54) **A METHOD FOR THE PRODUCTION OF CUBIC BORON NITRIDE-CONTAINING FILMS**

VERFAHREN ZUR HERSTELLUNG VON KUBISCHES BORNITRID ENTHALTENDEN FILMEN

PROCÉDÉ DE PRODUCTION DE FILMS CONTENANT DU NITRURE DE BORE CUBIQUE

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **18.02.2008 JP 2008036112**

(43) Date of publication of application:
**27.10.2010 Bulletin 2010/43**

(73) Proprietor: **Kabushiki Kaisha Kobe Seiko Sho
Chuo-ku
Kobe-shi
Hyogo 651-8585 (JP)**

(72) Inventors:
• **YAMAMOTO, Kenji
Kobe-shi,
Hyogo 651-8585 (JP)**
• **OKIMOTO, Tadao
Kobe-shi,
Hyogo 651-8585 (JP)**

(74) Representative: **TBK
Bavariaring 4-6
80336 München (DE)**

(56) References cited:
**JP-T- 9 510 500    US-A- 5 015 493**

• HE Q ET AL: "Deposition of c-BN on silicon substrates coated with diamond thin films", THIN SOLID FILMS, ELSEVIER-SEQUOIA S.A. LAUSANNE, CH, vol. 474, no. 1-2, 1 March 2005 (2005-03-01), pages 96-102, XP025387025, ISSN: 0040-6090 [retrieved on 2005-03-01]
• KULISCH ET AL: "Deposition of thick cubic boron nitride films - Mechanisms and concepts", THIN SOLID FILMS, ELSEVIER-SEQUOIA S.A. LAUSANNE, CH, vol. 516, no. 2-4, 17 November 2007 (2007-11-17), pages 216-222, XP022349519, ISSN: 0040-6090, DOI: 10.1016/J.TSF.2007.06.073

**Description**

The present invention reflates to a method for the production of cubic boron nitride-containing films and, particularly, a method of forming cubic boron nitride-containing films by means of magnetron sputtering method.

Prior art which is related to this field of technology can be found in e.g. the following non-patent literature Qi He et al, Thin Solid Films, vol. 474, no. 1-2, 1 March 2005, pages 96-102 disclosing deposition of c-BN on silicon substrates coated with diamond thin films, and in Wilhelm Kulisch et al, Thin Solid Films, vol. 516, no. 2-4, 17 November 2007, pages 216-222 disclosing deposition of thick cubic boron nitride films-Mechanisms and concepts.

Cubic boron nitride (hereinafter often referred to as "cBN") generally shows high hardness, high oxidation resistance and low reactivity to iron. Therefore, cBN has been used suitably in the past as a wear-resisting film, for example, for cutting tool, mold for metal forming, jig and tool, and the like. Various methods are conventionally proposed to form such cBN-based films.

As a method for production of the above-mentioned cBN-based films by CVD (Chemical Vapor Deposition), for example, a forming method by reacting a gas containing boron (B) (boron-containing gas) with a gas containing nitrogen (N) (nitrogen-containing gas) in plasma can be given. However, the above-mentioned CVD method has a disadvantage such that the use of a gas dangerous to handle such as $BH_3$ or $BF_4$ as raw material gas is unavoidable.

On the other hand, as a method for the production by PVD (Physical Vapor Deposition), for example, a method of performing reactive sputtering in a nitrogen-containing atmosphere by means of the magnetron sputtering method using a B (boron)-containing target can be given.

Examples of the B-containing target used in the above-mentioned PVD method include a hexagonal boron nitride (hBN) target. However, the hBN requires radio-frequency (RF) sputtering which involves an expensive power source and a complicate structure because hBN has no conductive property, and thus limits its industrial application.

As a technique which solved this problem, for example, a method for producing cubic boron nitride by generating a plasma by DC arc or DC magnetron cathode and performing sputtering while applying radio-frequency wave or DC voltage is proposed in Patent Literature 1 (D1), wherein a target composed of conductive boron carbide (preferably, a target composed of $B_4C$ (tetraboron carbide)) is used as the target, and the areal power to be applied to the target is controlled.

In the formation of cBN-based films by the PVD method, in order to stabilize cBN that is in a metastable state at the time of film formation, it is needed to impart a high energy to the film by ion irradiation during the film formation. When, for example, using (Ar+nitrogen) gas as the atmospheric gas and the above-mentioned $B_4C$ target as the target, the energy imparted to the film to be formed can be increased, according as the ratio of ions in the atoms and ions to be deposited increases. However, in the above-mentioned method of Patent Literature 1, rare gases, such as Ar, that are not main elements in a film are mainly ionized, while only several % of a target constituent material that is a main component of the film is ionized. When the ion concentration of B is low in this way, in order to impart great energy to the film by the ion irradiation, high ion energy must be imparted to individual ions. This requires increase in bias voltage to be applied to the substrate. However, the increased bias voltage enhances the residual stress of the formed film (hereinafter often referred to as "film stress"), causing peeling of the film or the like.

As a technique which can solve the above-mentioned problem, for example, Non-Patent Literature 1 (D2) discloses a method: providing conductive property to a boron target by heating it to about 800°C; and ionizing boron by means of arc discharge to deposit cBN on an upper layer of amorphous BN or hBN formed on a Si substrate. According to this method, cBN films can be formed without imparting of high ion energy. However, this technique has disadvantages such as the complication of the mechanism resulting from the necessity of heating the target to the above-mentioned high temperature and insufficient discharge stability for industrial application.

[Patent Literature 1] Japanese translation of PCT international application H9-510500

[Non-Patent Literature 1] G. Krannich et al., "Formation of cubic boron nitride thin films by reactive cathodic arc evaporation", Diamond and Related Materials 6 (1997), p. 1005-1009

In view of the above-mentioned circumstances, the present invention has an object to provide a method, to form cubic boron nitride-containing films by the magnetron sputtering method using a $B_4C$-containing target, which forms a cBN film lower in film stress than in the past by keeping the bias voltage to be applied to the substrate low.

The present invention provides a method, wherein, to form a cubic boron nitride-containing film (hereinafter often referred to as "cBN film") by means of the magnetron sputtering method using a boron carbide-containing target, the cBN film is formed under the following conditions (a), (b) and (c):

> (a) power input is pulsed;
> (b) input power pulse width is not more than 100 $\mu$s; and
> (c) maximum input power density in an erosion area of the target is at least 0.33 kW/cm$^2$.

According to this method, in addition to the ionization of atmospheric gas, the ionization of elements (particularly, boron) which constitute the target can be promoted during the film formation, and the bias voltage to be applied to the substrate can be consequently kept low. Therefore, cBN films lower in film stress than in the past can be formed.

These and other objects, features and advantages of the present invention will become obvious from the detailed description below and the accompanying drawings.

Fig. 1 is a graph showing relationships among the lowest bias voltage required to form cBN film, the film stress of cBN film formed at the bias voltage, and the maximum input power density; and

Fig. 2 is a schematic illustrative view of a film forming apparatus used in examples.

For the purpose of establishing a method for stably forming cBN films lower in film stress than in the past by means of magnetron sputtering method, the present inventors earnestly studied about a concrete means for promoting the ionization of, particularly, boron which constitutes the target during the film formation to reduce the bias voltage to be applied to the substrate more than in the past. As a result, the present inventors found that, for forming a cubic boron nitride-containing film by reacting boron which constitutes a $B_4C$-containing target having conductive property with nitrogen in a nitrogen-containing gas, it is best to use, as a magnetron sputtering evaporation source, a sputtering (called also high power pulse sputtering or HIPIMS (high power impulse magnetron sputtering)) device which can input high power in such an extremely short time as several microseconds to several hundreds microseconds, and to form the film under following conditions (a), (b) and (c) to promote ionization of boron constituting the target:

(a) power input is pulsed;
(b) input power pulse width is not more than 100 $\mu$s; and
(c) maximum input power density in an erosion area of the target is at least 0.33 kW/cm$^2$.

The "cubic boron nitride-containing film" (cBN film) mentioned above and below means a film having a ratio of cBN of not less than 50%, the ratio being defined by the following equation (1). The cBN film can include, . besides cBN, hexagonal boron nitride (hBN), C bonded to B in BN, and the like.

$$\text{Ratio of cBN (\%)} = [(\text{Peak intensity of cBN})/(\text{Peak intensity of cBN+Peak intensity of hBN})] \times 100 \quad \dots \quad (1)$$

wherein each of "peak intensity of cBN" and "peak intensity of hBN" means peak intensity (peak height) based on analysis by Fourier transform infrared spectrophotometer (FTIR).

A preferred embodiment of the present invention will be then described in detail. In this embodiment, a cubic boron nitride-containing film is formed while promoting the ionization of, particularly, boron which constitutes a $B_4C$-containing target by setting the maximum input power density in the erosion area of the target to at least 0.33 kW/cm$^2$. The erosion area is a region to be shaven by collision of ion or the like. In the conventional method, only the sputtering gas (atmospheric gas) such as Ar is ionized. However, by setting the maximum input power to at least 0.33 kW/cm$^2$, the ionization of target constituent materials (particularly, boron) sputtered from the target can be promoted, in addition to the ionization of the atmospheric gas. As a result, the bias voltage to be applied to the substrate can be remarkably reduced, compared with in the past, and the residual stress of the cBN film can be reduced more sufficiently than in the case of film formation with application of a conventional level of DC power. The above-mentioned maximum input power density is more preferably at least 1 kW/cm$^2$.

The higher maximum input power density is more preferable without particular limitation of the upper limit thereof. When a commercially available power source (about 18 MW) is used, for example, its upper limit is about 90 kW/cm$^2$. Even if the maximum input power density is remarkably increased, the effect of reducing the film stress tends to be saturated. Therefore, the maximum input power density is set preferably to the range between 0.55 (more preferably 1) and 2.7 kW/cm$^2$, and more preferably to the range between 1 and 2.7 kW/cm$^2$.

On the other hand, since continuous input (application) of such high power causes dissolution of the target by overheat, damage on the target due to the occurrence of arcing, or the like, the power which can be continuously input is limited. In this embodiment, therefore, the high power is inputted in a pulsed form. By adopting this method, it can be also avoided that the voltage becomes unstable when the input power is increased. Particularly, the occurrence of micro arcing in the target can be suppressed, and cBN films reduced in film stress can be formed as described above while suppressing mechanical damages such as the above-mentioned damage on the target.

More specifically, when the maximum input power density is set to at least 0.33 kW/cm$^2$, the input power pulse width (length per pulse) is set to not more than 100 $\mu$s (microseconds). The maximum input power density is increased by limiting the input power pulse width in this way, whereby the film formation can be stably performed while promoting the above-mentioned ionization and sufficiently suppressing the occurrence of the arcing or the like. The input power pulse width is set preferably to not more than 30 microseconds. Thereby, the occurrence of the micro arcing in the target which is apt to occur upon input of higher power can be suppressed, and the power to be instantaneously input can be raised to the thermal limit of the target. Consequently, the bias voltage can be sufficiently reduced, and cBN films further reduced in film stress can be obtained.

The lower limit of the input power pulse width is about 3 microseconds. In the method of this embodiment, the atmospheric gas (e.g., Ar) is excited in the early stages of the film formation. After about 3 microseconds from the excitation, the excited Ar or electrons collide with the target, and whereby the target constituent materials start to ionize. Therefore, if the input power pulse width is shorter than 3 microseconds, the target constituent materials cannot be sufficiently ionized. The input power pulse width is set preferably to not less than 5 microseconds. From such a point of view, it is preferable that the input power pulse width is set not more than 100 microseconds and set as wider as possible within the range where discharge voltage does not become destabilized and the target is not overheated.

The period of the input power pulse may be set within the range between several tens microseconds and several microseconds.

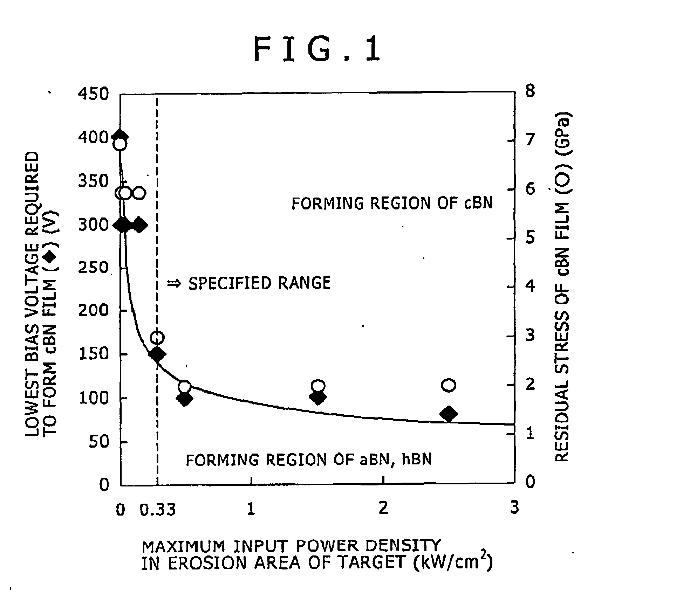

Fig. 1 is a graph formed using examples to be hereinafter described, which shows relationships among the lowest bias voltage required to form cBN film, the residual stress (film stress) of cBN film formed at the bias voltage, and the maximum input power density. The horizontal axis of Fig. 1 shows the maximum input power density in the erosion area of the target that is represented by unit of $kW/cm^2$, the left vertical axis shows the lowest bias voltage required to form cBN film that is represented by unit of V, and the right vertical axis shows the residual stress of the cBN film that is represented by unit of GPa. The lowest bias voltage required to form cBN film is plotted by ♦, and the residual stress of cBN film formed by applying the lowest bias voltage is plotted by o.

The following can be considered from Fig. 1. Namely, it is understood that the lowest bias voltage required to form cBN film can be reduced by inputting the power in the pulsed form, and increasing the maximum input power density. This shows that the target constituent elements in particular are sufficiently ionized by increasing the power to be instantaneously input, and the energy required to stabilize cBN can be imparted to the film without increasing the bias voltage, and as a result, cBN films with small film stress can be formed. It is understood that, by setting the maximum input power density to at least 0.33 $kW/cm^2$ in particular, the film stress of cBN film can be remarkably reduced to 3 GPa or less, compared with the case of application of DC power at a conventional level of input power density (the case of film formation by DC sputtering), and cBN films with satisfactory adhesiveness to substrate can be formed.

In this embodiment, further, it is preferred to set the (average power/the area of the target) to not more than 82$W/cm^2$. And thereby, the overheat of the target can be suppressed to reduce the occurrence of mechanical defects such as cracking, breakage or deformation on the surface of the formed film.

The "average power" mentioned above and below is determined from the following expression (2). If the power at the time of input is constant, the average power is represented by (input power × duty ratio), wherein the

$$\text{duty ratio} (-) = \text{pulse width} \times \text{frequency.}$$

$$\frac{1}{T}\int_0^T (\text{input power})dt \quad \dots \quad (2)$$

wherein T is pulse period, and t is time.

The input power is set preferably from 3 kW to 500 kW when a target having a diameter of 6 inches, for example, is used in a general magnetron. The ionization of the target constituent elements can be sufficiently promoted by setting the input power to 3 kW or more, and the overheat of the target during film formation can be suppressed by setting the input power to 500 kW or less, to form cBN films with satisfactory surface properties.

In this embodiment, a nitrogen-containing gas is used as the atmospheric gas. Examples of the nitrogen-containing gas include a mixed gas of $N_2$ or $NH_3$ and a rare gas (Ar, etc.). In this case, it is preferable to set the partial pressure ratio of $N_2$ or $NH_3$ to, for example, 10 to 50%.

The $B_4C$-containing target used in this embodiment can include a binder or the like besides $B_4C$. Since the carbon included in the target reacts with nitrogen in the atmosphere during film formation, and is eliminated as an unstable C-N compound from the formed cBN film, the carbon residual amount in the cBN film is generally 10 at% or less.

In this embodiment, unbalanced magnetron sputtering method is preferably adopted as the magnetron sputtering method.

The present invention will be then described more specifically in reference to examples. The present invention is never limited by the following examples, and can be carried out with variations adaptable to the gist described above and to be described below, and such variations are included in the technical scope of the present invention.

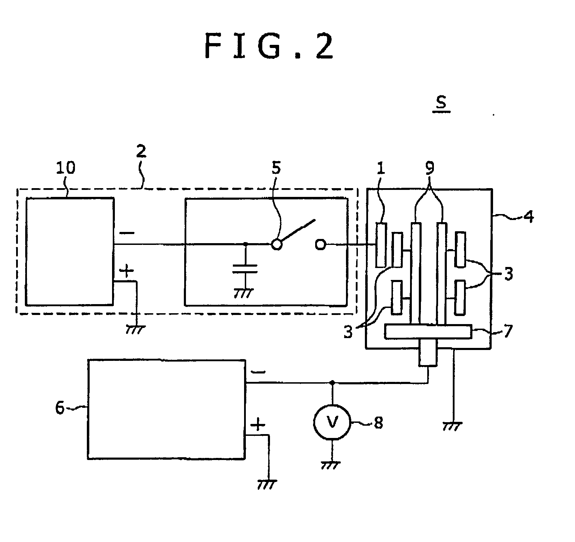

An apparatus schematically shown in Fig. 2 was used. In Fig. 2, an exhaust device, a gas supply device or the like is not shown. A cubic boron nitride-containing film forming apparatus S shown in Fig. 2 includes: a target 1; a sputtering pulse power source 2; a chamber 4; a bias power source 6; a bias table 7; a voltage measuring instrument 8; and a substrate holder 9. The sputtering pulse power source 2 includes a DC power source 10 and a switching element 5. The target 1, the bias table 7, and the substrate holder 9 are disposed within the chamber 4, and a substrate 3 is disposed within the chamber 4 while being attached to the substrate holder 9. The DC power source 10 is connected to the target 1 through the switching element 5. The bias power source 6 is configured so that DC bias voltage can be applied to the substrate 3, and the voltage measuring instrument 8 is connected to a conductive path extending from the bias power source 6 to the substrate 3 so that it can detect the DC bias voltage.

For more detail, the $B_4C$-containing target 1 having a diameter of 6 inches was attached to a magnetron sputtering evaporation source having a discharge area (the area of erosion area) of about 182.41 $cm^2$. The area of the target is equal to the area of the erosion area.

At the start of film formation, the gas within the chamber 4 was exhausted once so that the inside of the chamber 4 was in a predetermined vacuum condition, and $ArN_2$ ($N_2$: 50%) was thereafter introduced thereto as sputtering gas (atmospheric gas) so that the internal pressure of the chamber 4 was 0.4 Pa. Then, sputtering was performed for 60 minutes to form a film (film thickness: about 1 $\mu$m) on the substrate 3 under the conditions that: using the sputtering pulse power source (5 MW) 2 provided with the general DC power source (30 kW) 10 to input power so as to attain the maximum power input density and pulse width shown in Table 1; applying DC bias voltage to the substrate (Si wafer) 3 attached to the substrate holder 9 set on the rotary bias table 7 by means of the bias power source 6; and the temperature of the substrate 3 is 500°C. The above-mentioned sputtering pulse power source 2 is configured so that the output of the DC power source 10 can be pulsed by ON/OFF drive of the switching element 5. The DC bias voltage is detected by the voltage measuring instrument 8.

The lowest bias voltage required to form cBN film shown in Fig. 1 was determined as follows: at each maximum input power density shown in Fig. 1, the film formation was carried out while varying the bias voltage, each of the resulting films was analyzed by the FTIR method to determine respective peak intensities of cBN and hBN in the film, and the ratio of cBN was determined according to the above-mentioned expression (1). The lowest value of bias voltage at which cBN films with the ratio of cBN being 50% or more could be formed was determined.

Further, the residual stress (film stress) of cBN films formed by applying the above-mentioned lowest bias voltage was computationally determined based on warping of the cBN films formed on Si wafers of 0.1 mm in thickness. These results are shown in Table 1.

[Table 1]

| No. | Input power | Maximum input power density | Input power pulse width | Frequency | Duty ratio | Average power | (Average power)/ (Area of target)* | Lowest bias power required to form cBN film | Residual stress of cBN film |
|---|---|---|---|---|---|---|---|---|---|
| | kW | $kW/cm^2$ | microsecond | kHz | % | kW | $W/cm^8$ | V | GPa |
| 1 | 3 | 0.016 | - | - | 100 | 3 | 16 | 300 | 6 |
| 2 | 3 | 0.016 | 30 | 1 | 3 | 0.09 | 0.5 | 400 | 7 |
| 3 | 10 | 0.055 | 30 | 1 | 3 | 0.3 | 2 | 300 | 6 |
| 4 | 30 | 0.16 | 30 | 1 | 3 | 0.9 | 5 | 300 | 6 |
| 5 | 60 | 0.33 | 30 | 1 | 3 | 1.8 | 10 | 150 | 3 |
| 6 | 100 | 0.55 | 5 | 6 | 3 | 3 | 16 | 100 | 2 |
| 7 | 100 | 0.55 | 10 | 3 | 3 | 3 | 16 | 100 | 2 |
| 8 | 100 | 055 | 20 | 1.5 | 3 | 3 | 16 | 100 | 2 |
| 9 | 100 | 055 | 30 | 1 | 3 | 3 | 16 | 100 | 2 |
| 10 | 100 | 0.55 | 60 | 1 | 5 | 5 | 27 | 100 | 2 |
| 11 | 100 | 0.55 | 70 | 1 | 7 | 7 | 38 | 100 | 2 |
| 12 | 100 | 0.55 | 100 | 1 | 10 | 10 | 55 | 100 | 2 |

(continued)

| No. | Input power | Maximum input power density | Input power pulse width | Frequency | Duty ratio | Average power | (Average power)/ (Area of target)* | Lowest bias power required to form cBN film | Residual stress of cBN film |
|-----|-------------|------------------------------|--------------------------|-----------|------------|---------------|-------------------------------------|----------------------------------------------|------------------------------|
| | kW | kW/cm$^2$ | microsecond | kHz | % | kW | W/cm$^8$ | V | GPa |
| 13 | 300 | 1.6 | 30 | 1 | 3 | 9 | 49 | 100 | 2 |
| 14 | 600 | 2.7 | 10 | 1 | 1 | 5 | 27 | 80 | 2 |
| 15 | 500 | 2.7 | 20 | 1 | 2 | 10 | 55 | 80 | 2 |
| 16 | 500 | 2.7 | 30 | 1 | 3 | 15 | 82 | 80 | 2 |
| 17 | 1000 | 5.5 | 30 | 1 | 3 | 30 | 164 | Overheat of target | - |
| 18 | 100 | 0.55 | 200 | 1 | 20 | 20 | 110 | The pulse power applied to the target is destabilized. | - |

* The area of the target is 182.41 cm$^2$.

The followings can be considered from Table 1 (Nos. described blow correspond to the numbers shown in Table 1, respectively). In Nos. 5 to 16, the lowest bias voltage for formation of cBN film can be kept low since the cBN films are formed on the above-mentioned specified conditions, and cBN films with small film stress are consequently obtained. It is understood from Nos. 5 to 16 that even if the input power pulse width is 5, 10 or 20 microseconds, stable film formation can be performed while reducing the residual stress of cBN film. Thus, by reducing the input power pulse width in this way, the power to be instantaneously input can be set large while reducing the average power, and even a power source with low capacity can be industrially used to form cBN films with small film stress.

On the other hand, it is understood that the lowest bias voltage required to form cBN film is increased in Nos. 1 to 4 and 18, since the formation of cBN film is not performed under the specified conditions, resulting in increased film stress or insufficient formation of cBN film itself.

In detail, No.1 shows a case in which DC power was input, and Nos. 2 to 4 show cases in which the input of power is pulsed, but the maximum input power density was below the specified lower limit. In each of these cases, the lowest bias voltage required to form cBN film must be increased, resulting in formation of cBN film with high film stress.

In the case shown by No. 18, when increasing the maximum input power density, micro arcing started to occur outside the erosion area of the target due to the excessively long pulse width to destabilize the pulse power, so that the film formation could not be performed under the specified conditions.

It is understood from the case shown by No. 17 that in order to suppress the occurrence of mechanical defects such as cracking, breakage or deformation on the surface of the formed film by suppressing the overheat of the target, it is best to keep the (average power)/(area of target) within the recommended range. Even in such a case, the overheat of the target can be solved by enhancing the cooling efficiency (for example, by increasing the flow rate of cooling water, etc.), and cBN films can be formed.

Among various embodiments of techniques disclose in the present specification as described above, principal techniques will be then summarized.

In one embodiment, a method of forming cubic boron nitride-containing films: wherein a boron carbide (preferably, B$_4$C (tetraboron carbide))-containing target is used; and wherein boron which constitutes the target is reacted with nitrogen in a nitrogen-containing gas to form a cubic boron nitride-containing film by means of the magnetron sputtering method; and wherein the film is formed under following conditions (a), (b) and (c) to promote ionization of boron constituting the target: (a) power input is pulsed; (b) input power pulse width is not more than 100 μs; and (c) maximum input power density in an erosion area of the target is at least 0.33 kW/cm$^2$.

According to this structure, when a cBN film is formed by the magnetron sputtering method using a boron carbide (preferably, B$_4$C)-containing target, the ionization of elements (particularly, boron) constituting the target can be promoted, in addition to the ionization of atmospheric gas, during the film formation, and the bias voltage to be applied to the substrate can be kept low. Therefore, according to this structure, cBN films lower in film stress than in the past can be formed. Further, stable formation of the above-mentioned cBN films with small film stress can be performed in an industrial scale since the complication of the mechanism, the destabilization of discharge, or the like as in Literature D2 can be eliminated.

In another embodiment, (average power/area of the target) is set preferably to not more than 82 W/cm$^2$.

In the other embodiment, the input power pulse width is set preferably to not more than 30 $\mu$s.

The present invention can provide a method of forming cubic boron nitride-containing films by means of magnetron sputtering method.

## Claims

1. A method of forming cubic boron nitride-containing films:

   wherein a boron carbide-containing target is used; and
   wherein boron which constitutes said target is reacted with nitrogen in a nitrogen-containing gas to form a cubic boron nitride-containing film by means of the magnetron sputtering method; and
   wherein said film is formed under following conditions (a), (b) and (c) to promote ionization of boron constituting said target:

   (a) power input is pulsed; and
   (b) input power pulse width is not more than 100 $\mu$s;
   **characterized in that**
   (c) maximum input power density in an erosion area of said target is at least 0.33 kW/cm$^2$.

2. The forming method according to claim 1, wherein (average power/area of said target) is not more than 82 W/cm$^2$.

3. The forming method according to claim 1 or 2, wherein said input power pulse width is not more than 30 $\mu$s.

## Patentansprüche

1. Verfahren zum Bilden einer kubisches Bornitrid enthaltenden Schicht, wobei ein Borkarbid enthaltendes Target verwendet wird; und
   wobei Bor aus diesem Target mit Stickstoff in einem Stickstoff enthaltenden Gas reagiert, um durch das Magnetron-Sputtering-Verfahren eine kubisches Bor-Nitrid enthaltende Schicht zu bilden; und
   wobei die Schicht unter folgenden Bedingungen (a), (b) und (c) gebildet wird, um eine Ionisation von Bor aus dem Target zu befördern:

   (a) eine eingegebene Leistung wird gepulst; und
   (b) eine Eingabeleistungspulsbreite ist nicht mehr als 100 $\mu$s;
   **dadurch gekennzeichnet, dass**
   (c) eine maximale Eingabeleistungsdichte in einem Erosionsgebiet des Targets zumindest 0,33 kW/cm$^2$ ist.

2. Bildungsverfahren nach Anspruch 1, wobei (Durchschnittsleistung/Fläche des Targets) nicht mehr als 82 W/cm$^2$ ist.

3. Bildungsverfahren nach einem der Ansprüche 1 oder 2, wobei die Eingangsleistungspulsbreite nicht mehr als 30 $\mu$s ist.

## Revendications

1. Procédé de formation de films contenant du nitrure de bore cubique :

   - **caractérisé en ce qu'**une cible contenant du carbure de bore est utilisée ; et
   - **en ce que** le bore constituant ladite cible est mise en réaction avec de l'azote dans un gaz contenant de l'azote afin de former un film contenant du nitrure de bore cubique à l'aide d'un procédé de pulvérisation cathodique magnéton ; et
   - **en ce que** ledit film est formé dans les conditions suivantes (a), (b) et (c) afin de promouvoir la ionisation du bore constituant ladite cible :

(a) l'énergie entrée est pulsée ; et
(b) la largeur d'impulsion d'énergie entrée n'est pas supérieure à 100 $\mu$s ; et
**caractérisé en ce que**
(c) la densité d'énergie entrée maximale dans la zone d'érosion de ladite cible est au moins égale à 0,33 kW/cm$^2$.

2. Procédé de formation selon la revendication 2, **caractérisé en ce que** (la moyenne de poudre par surface de ladite cible) n'est pas supérieure à 82 W par cm$^2$.

3. Procédé de formation selon une des revendications de 1 à 2, **caractérisé en ce que** la largeur d'impulsion d'énergie entrée n'est pas supérieure à 30 $\mu$s.

# F I G . 1

LOWEST BIAS VOLTAGE REQUIRED TO FORM cBN FILM (◆) (V)

RESIDUAL STRESS OF cBN FILM (O) (GPa)

FORMING REGION OF cBN

⇒ SPECIFIED RANGE

FORMING REGION OF aBN, hBN

MAXIMUM INPUT POWER DENSITY
IN EROSION AREA OF TARGET (kW/cm²)

# FIG.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H9510500 W

**Non-patent literature cited in the description**

- **QI HE et al.** *Thin Solid Films,* 01 March 2005, vol. 474 (1-2), 96-102
- **WILHELM KULISCH et al.** *Thin Solid Films,* 17 November 2007, vol. 516 (2-4), 216-222
- **G. KRANNICH et al.** Formation of cubic boron nitride thin films by reactive cathodic arc evaporation. *Diamond and Related Materials,* 1997, vol. 6, 1005-1009